# EUROPÄISCHE PATENTANMELDUNG

(11) **EP 2 887 105 A1**
(43) Veröffentlichungstag der Anmeldung: **24.06.2015**
(21) Anmeldenummer: 14188717.4
(22) Anmeldetag: 14.10.2014
(51) Int. Cl.: G01V 8/20, G01S 17/48, H03K 17/94

(54) **Optoelektronischer Sensor und Verfahren zur Erfassung glänzender Objekte**

(30) Priorität: 18.12.2013 DE 102013114325
(71) Anmelder: SICK AG, 79183 Waldkirch (DE)
(72) Erfinder: Merettig, Gerhard, 79350 Sexau (DE)
(74) Vertreter: Hehl, Ulrich

(57) **Zusammenfassung**

Es wird ein optoelektronischer Sensor (10) zur Erfassung glänzender Objekte (24) angegeben, wobei der Sensor (10) einen Lichtsender (12) zum Aussenden eines divergenten Strahlenbündels (22), einen ortsauflösenden Lichtempfänger (16) sowie eine Auswertungseinheit (20) aufweist, um bei Erfassen eines Objekts (24) an einer Erfassungsposition (30) ein Schaltsignal zu erzeugen. Dabei ist die Auswertungseinheit (20) dafür ausgebildet, auf dem Lichtempfänger (16) eine Schaltposition (32) entsprechend der Erfassungsposition (30) festzulegen und das Schaltsignal in Abhängigkeit von der Position eines Empfangslichtflecks (26) auf dem Lichtempfänger (16) bezüglich der Schaltposition (32) zu erzeugen.

## Beschreibung

Die Erfindung betrifft einen optoelektronischen Sensor zur Erfassung glänzender Objekte sowie ein Verfahren zum Erzeugen eines Schaltsignals bei Erfassung glänzender Objekte nach dem Oberbegriff von Anspruch 1 beziehungsweise 10.

Eine häufige Anwendung für einen optischen Sensor ist, die Anwesenheit eines Objekts zu erkennen. Oft werden sie als Schalter eingesetzt, die bei Ein- beziehungsweise Austritt eines Objekts in den Erfassungsbereich den Schaltzustand wechseln. Bekannt sind Einweglichtschranken, in denen ein Lichtsender einen Sendestrahl auf einen gegenüberliegenden Lichtempfänger sendet, so dass durch Lichtunterbrechung ein Objekt im Strahlengang erkannt wird. In einer Variante als Reflexionslichtschranke sind Lichtsender und Lichtempfänger am selben Ort angebracht und der Strahl wird durch einen Reflektor zurückgeworfen.

Eine weitere bekannte Familie von optoelektronischen Sensoren bilden Lichttaster, bei denen ähnlich einer Reflexionslichtschranke Lichtsender und Lichtempfänger in einem Gehäuse untergebracht sind. Allerdings wird hier der Sendestrahl frei in den Raum gerichtet und von einem Objekt remittiertes oder reflektiertes Licht im Lichtsender detektiert. Hier ist also ein Objekt im Strahlengang das detektierte Ereignis, welches zu Lichtempfang führt, während bei einer Lichtschranke umgekehrt im objektfreien Zustand der Strahl empfangen und durch das Objekt der Lichtempfang unterbrochen wird.

Es gibt auch innerhalb der Lichttaster unterschiedliche Ausführungen. Ein energetischer Taster bewertet für eine binäre Objektfeststellung die Intensität des Empfänger-signals anhand einer Schaltschwelle. Bei einem Triangulationstaster stehen die optischen Achsen von Lichtsender und Lichtempfänger schräg zueinander und mit Hilfe eines ortsauflösenden Lichtempfängers kann der Winkel gemessen werden, unter dem ein Objekt erfasst wird. Dadurch wird eine Entfernungsbestimmung ermöglicht. Hinter-grundausblendende Lichttaster bilden eine Art Hybrid. Wie in einem energetischen Lichttaster wird lediglich ein binäres Objektfeststellungssignal erzeugt und kein Entfernungswert gemessen. Zugleich wird aber der Aufbau eines Triangulationstasters ausgenutzt, um mit einem zumindest in einen Nah- und einen Fernbereich ortsauflösenden Lichtempfänger zwei Empfangssignale zu erzeugen. Deren Differenz wird mit einer Schaltschwelle bewertet, um so die Objekterfassung auf einen bestimmten Entfernungsbereich zu beschränken und Empfangssignale von Objekten außerhalb dieses Entfernungsbereichs als Hintergrundsignal auszublenden. Ein hintergrundausblendender Lichttaster ist beispielsweise in der DE 197 21 105 C2 offenbart, wobei hier Schalter vorgesehen sind, um die einzelnen Elemente eines ortsauflösenden Lichtempfängers auf veränderliche Weise dem Nah- oder Fernbereich zuzuordnen.

Ein mattes oder streuendes Objekt ist verhältnismäßig einfach und zuverlässig detektierbar. Es streut den Sendestrahl in alle Richtungen. Somit ist bei Lichtschranken eine Strahlunterbrechung und bei Lichttastern ein Empfang zumindest eines Teils des remittierten Lichts gewährleistet. Viele im industriellen Umfeld zu detektierende Objekte haben aber eine glänzende Oberfläche, und dieser Glanz führt leicht zu Fehldetektionen. Beispiele hierfür sind metallische Objekte, plane Kunststoffe oder Glas.

Bei Reflexionslichtschranken können zur Glanzunterdrückung Polfilter eingesetzt werden. Dadurch sollen die durch Glanz verursachten hohen Signalamplituden unterdrückt werden. Solche Polfilter arbeiten aber nicht ideal und dämpfen deshalb unvollständig, und depolarisierende Materialien wie Kunststofffolien reduzieren die Wirksamkeit zusätzlich. Polfilter verhindern deshalb Fehldetektionen nur teilweise.

Bei der Detektion transparenter Objekte, beispielsweise Glasscheiben, wird das Transmissionssignal an Vorder- und Rückseite um lediglich 4% und damit insgesamt um etwa 8% gedämpft. Diese geringe Dämpfung ist in vielen Anwendungen nicht einfach zu erkennen.

In Lichttastern mit Vorder- oder Hintergrundausblendung verschieben Glanzreflexe den Schwerpunkt des Empfangslichtflecks, und daraus ergeben sich Abstandsfehler oder bei vollständiger Umlenkung des Strahls sogar völlig falsche Abstandswerte.

Die DE 10 2006 057 878 A1 betrifft eine optoelektronische Vorrichtung mit einem ein Sendelichtstrahlbündel emittierenden Sender und einem eine Linearanordnung von Empfangselementen aufweisenden Empfänger, bei dem durch eine Amplitudenbewertung selektiv glänzende Objekte erfasst werden. Eine zweigeteilte Empfangsoptik sorgt dafür, dass auf dem Empfänger zwei getrennte Empfangslichtflecken erzeugt werden.

In der EP 0 519 409 B1 wird ein Glanzdetektor vorgestellt, der eine LED mit einer Projektionslinse zur Beleuchtung eines breiten Bereichs und einen Zeilensensor umfasst. Zur Auswertung werden Empfangssignale aus Reflexion und diffuser Remission verglichen.

Es ist daher Aufgabe der Erfindung, einen optoelektronischen Sensor zur Erkennung glänzender Objekte weiterzubilden.

Diese Aufgabe wird durch einen optoelektronischen Sensor zur Erfassung glänzender Objekte sowie ein Verfahren zum Erzeugen eines Schaltsignals bei Erfassung glänzender Objekte nach Anspruch 1 beziehungsweise 10 gelöst. Dabei wird divergentes Licht ausgesandt, damit unabhängig von der Orientierung einer zu erfassenden glänzenden Objektoberfläche zumindest ein Teil des ausgesandten Lichts den Lichtempfänger erreicht. Die Erfindung geht dann von dem Grundgedanken aus, ein Schalten bei einer gewünschten Erfassungsposition des Objekts zu erreichen, indem die Position des Empfangslichtflecks auf dem ortsauflösenden Lichtempfänger ausgewertet wird. Diese Auswertung erfolgt vorzugsweise, indem die Position des Empfangslichtflecks mit einer Schaltposition auf dem Lichtempfänger verglichen wird. Die Schaltposition ist also eine interne Position auf dem Lichtempfänger, welche der externen Erfassungsposition im Objektraum entspricht.

Eine wichtige Anwendung ist die Montage des Sensors an einem Objektstrom, der in einer Förderrichtung den Sensor passiert. Der Schaltvorgang soll dann jeweils stattfinden, sobald ein Objekt in die Erfassungsposition gefördert wurde, um für durch den Schaltvorgang ausgelöste, nachgeordnete Bearbeitungsschritte eine definierte Situation zu schaffen. Wird die Schaltposition vorab festgelegt, beispielsweise in der Mitte des Lichtempfängers, so bedarf es einer Justierung, damit die Schaltposition der gewünschten Erfassungsposition entspricht. Alternativ ist denkbar, die Schaltposition für den Betrieb anzupassen und dadurch eine aufwändige Montage des Sensors zu vermeiden.

Die Erfindung hat den Vorteil, dass mit herkömmlichen Sensoren kaum erfassbare Objekte in einer präzise festgelegten Erfassungsposition verlässlich einen Schaltvorgang auslösen. Beispielsweise sind spiegelnde Objekte wie metallische glänzende Oberflächen, transparente Objekte wie Glas sowie stark dämpfende, aber doch glänzende Objekte wie schwarz lackierte Oberflächen oder Solarzellen erkennbar. Die Erkennung funktioniert für plane wie unregelmäßige Oberflächen, etwa auch bei runden Konturen von Glas- und PET-Flaschen.

Die Auswertungseinheit ist bevorzugt dafür ausgebildet, ein Summensignal des Lichtempfängers zu bilden, zu dem die Positionen des Lichtempfängers mit einem Gewichtungsfaktor beitragen, der anhand der jeweiligen Position und der Schaltposition festgelegt ist. Bei einem diskreten Lichtempfänger entsprechen die Positionen des Lichtempfängers vorzugsweise dessen einzelnen Lichtempfangselementen oder Pixeln. Durch Festlegen der Gewichtungsfaktoren genügt eine summarische Betrachtung, um das Schaltsignal zu gewinnen. Abgesehen von dem Summieren beziehungsweise Integrieren muss nur noch das eine Summensignal statt der zahlreichen ortsaufgelösten Einzelsignale betrachtet werden. Das Auswerten des Summensignals erfolgt beispielsweise durch Schwellbewertung.

Die Schaltposition teilt bevorzugt den Lichtempfänger in zwei Bereiche, wobei Positionen in dem einen Bereich mit einem positiven Gewichtsfaktor und Positionen in dem anderen Bereich mit einem negativen Gewichtsfaktor zu dem Summensignal beitragen. Bei einem zeilenförmigen Lichtempfänger wird so die Schaltposition zum Übergang von einem linken Bereich mit negativer Gewichtung zu einem rechten Bereich mit positiver Gewichtung oder umgekehrt. Bei einem zweidimensionalen Lichtempfänger werden entsprechend zwei Vorzeichenklassen anhand einer Teilungslinie durch die Schaltposition gebildet. Die Gewichtung stellt sicher, dass ein in Relativbewegung zu dem Sensor befindliches Objekt erst durch den aufgrund von Glanz reflektierten Empfangslichtfleck und damit in der Erfassungsposition einen Schaltvorgang auslöst.

Die Auswertungseinheit ist bevorzugt dafür ausgebildet, die Schaltposition zu verschieben. Die Schaltposition korrespondiert mit der Erfassungsposition, und durch diese elektronische Anpassung muss nicht physisch der Sensor justiert oder gar neu montiert werden.

Dem Lichtsender ist bevorzugt eine Streulinse vorgeordnet. Dadurch entsteht das divergente Strahlenbündel. Denkbar ist, dass schon der Lichtsender selbst divergentes Licht erzeugt, etwa als LED. Dann sorgt die Streulinse für eine zusätzliche Strahlaufweitung, oder es wird auf die Streulinse verzichtet, sofern die Abstrahlcharakteristik des Lichtsenders bereits den Anforderungen genügt. Wenn der Lichtempfänger nur in einer Richtung ortsauflösend ist, wie im Fall einer Empfängerzeile, kann die Streulinse entsprechend nur in einer Dimension aufstreuend gestaltet sein, beispielsweise als Zylinderlinse. Eine derartige Linse kann auch in der einen Richtung aufstreuen und in der anderen Richtung fokussieren, beziehungsweise in einer Richtung das schon ursprünglich divergente Licht eines Lichtsender etwas weniger divergent machen.

Der Lichtempfänger weist bevorzugt eine Vielzahl zeilenförmig angeordneter Lichtempfangselemente auf. Damit ist der Sensor eindimensional für Erfassungspositionen längs einer Richtung ausgebildet, etwa zur Erfassung von Objekten in einem Objektstrom, der sich in einer Förderrichtung bewegt. Alternativ ist auch denkbar, einen Lichtempfänger mit matrixförmig angeordneten Lichtempfangselementen zu verwenden. Dadurch können entweder Erfassungspositionen in zwei Dimensionen festgelegt werden, oder die Spalten der Matrix werden gemeinsam betrachtet beziehungsweise in den Spalten nur repräsentative Lichtempfangselemente verwendet, um effektiv einen Zeilensensor größerer Breite oder einen in Spaltenrichtung elektronisch justierbaren Zeilensensor zu erhalten.

Dem Lichtempfänger ist bevorzugt eine torische Empfangslinse vorgeordnet. Dies ist besonders für eindimensionale Ausführungsformen des Sensors geeignet, um den Empfangslichtfleck für eine präzise Positionsauswertung in einer Richtung zu fokussieren und in der dazu orthogonalen anderen Richtung breit zu lassen. Dadurch trifft der Empfangslichtfleck ohne besondere Justageanforderungen auch einen als schmaler Zeilensensor ausgebildeten Lichtempfänger

Die Auswertungseinheit ist bevorzugt dafür ausgebildet, ein glänzendes Objekt anhand der Größe eines Empfangslichtflecks zu erkennen. Wird Empfangslicht von einem diffus remittierenden Objekt empfangen, so entsteht wegen der ungerichteten Remission ein deutlich breiterer Empfangslichtfleck. Dies kann die Auswertungseinheit beispielsweise anhand der Anzahl von Positionen erkennen, an denen Licht empfangen wird.

Die Auswertungseinheit ist bevorzugt dafür ausgebildet, die Empfangssignale eines glänzenden Referenzhintergrundes als Referenzsignal einzulernen und ein Objekt vor dem Referenzhintergrund anhand einer Veränderung gegenüber dem Referenzsignal zu erkennen. Der glänzende Referenzhintergrund schafft eine charakteristische Erwartungshaltung, an welchen Positionen auf dem Lichtempfänger Empfangslichtflecken auftreten sollten. Ein Objekt, das den Referenzhintergrund verdeckt, verhindert die Ausbildung dieser Empfangslichtflecken und ist daher zuverlässig von der Erwartungshaltung unterscheidbar.

Das erfindungsgemäße Verfahren kann auf ähnliche Weise weitergebildet werden und zeigt dabei ähnliche Vorteile. Derartige vorteilhafte Merkmale sind beispielhaft, aber nicht abschließend in den sich an die unabhängigen Ansprüche anschließenden Unteransprüchen beschrieben.

Die Erfindung wird nachstehend auch hinsichtlich weiterer Merkmale und Vorteile beispielhaft anhand von Ausführungsformen und unter Bezug auf die beigefügte Zeichnung näher erläutert. Die Abbildungen der Zeichnung zeigen in:
- Fig. 1: eine schematische Schnittansicht eines Sensors mit dessen Strahlengang;
- Fig. 2a-b: schematische Schnittansichten des Sensors gemäß Figur 1 mit dessen Strahlengang für Objekte mit planer Oberfläche unterschiedlicher Neigung;
- Fig. 3a-b: eine schematische Schnittansicht des Sensors gemäß Figur 1 mit dessen Strahlengang für Objekte mit runder Oberflächenkontur;
- Fig. 4: eine Ansicht des Lichtempfängers mit Illustration von Gewichtungsfaktoren und Schaltposition bei Bilden eines Summensignals;
- Fig. 5a-c: im linken Teil eine schematische Schnittansicht des Sensors gemäß Figur 1 und dessen Strahlengang an einem Objekt mit planer Oberfläche in verschiedenen Förderpositionen, und im rechten Teil eine Ansicht des Lichtempfängers und der darauf entstehenden Empfangslichtflecken; und
- Fig. 6a-b: eine schematische Schnittansicht eines Sensors mit dessen Strahlengang vor einem Referenzhintergrund beziehungsweise wenn ein Objekt den Referenzhintergrund verdeckt.

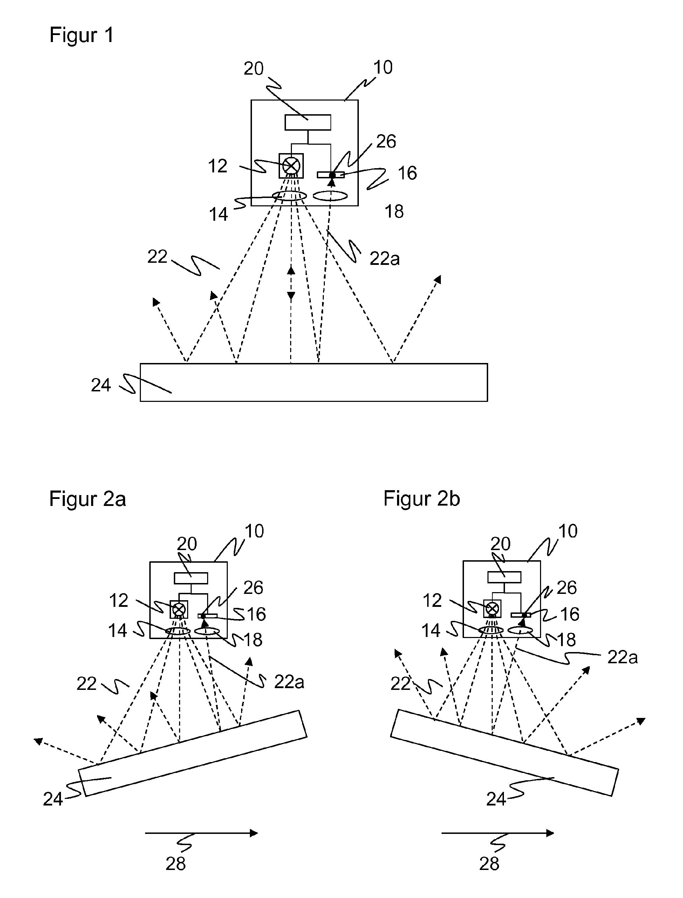

Figur 1 zeigt eine schematische Schnittansicht eines Sensors 10, der einen Lichtsender 12 mit einer Sendeoptik 14 sowie einen Lichtempfänger 16 mit einer Empfangsoptik 18 aufweist. Eine Auswertungseinheit 20 ist mit Lichtsender 12, um dessen Aktivität zu steuern, und mit Lichtempfänger 16 verbunden, um dessen Empfangssignal auszuwerten.

Der Sensor 10 ist damit ähnlich einer Reflexionslichtschranke oder einem Lichttaster aufgebaut. Allerdings ist das Sendelicht 22 nicht wie üblich fokussiert, sondern divergent. Die Divergenz wird erreicht, indem eine dafür geeignete Sendeoptik 14 gewählt wird, beispielsweise eine Streulinse. Denkbar ist auch, dass der Lichtsender 12, beispielsweise eine LED, selbst schon divergentes Sendelicht erzeugt und auf eine Sendeoptik 14 verzichtet wird. Abhängig von den möglichen Verkippungen eines zu erfassenden Objekts 24 kann das Sendelicht 22 ein- oder zweidimensional aufgeweitet werden. Für den erstgenannten Fall wird beispielsweise eine konkave Zylinderlinse verwendet.

Der Lichtempfänger 16 ist ortsauflösend, also in der Lage, die Position eines Empfangslichtflecks 26 auf dem Lichtempfänger 16 zu bestimmen. Obwohl im Prinzip eine analoge Ausführung als PSD (Position Sensitive Device) denkbar ist, wird vorzugsweise ein Diodenarray oder ein in Pixel aufgelöster Chip beispielsweise in CCD- oder CMOS-Technologie eingesetzt. Wie schon im letzten Absatz angedeutet, ist eine zweidimensionale Ausführungsform des Sensors 10 denkbar. In vielen Anwendungen wird eine Ortsauflösung aber nur in einer Richtung benötigt, und deshalb wird im Folgenden zur erleichterten Veranschaulichung jeweils ein Lichtempfänger 16 verwendet, der als Empfängerzeile ausgebildet ist. In diesem Fall ist vorteilhaft, wenn die Empfangsoptik 18 eine torische Linse aufweist, die den Empfangslichtfleck 26 nur in Zeilenrichtung fokussiert, nicht jedoch senkrecht zu der Zeilenrichtung. Dadurch wird die Ortsauflösung des Zeilensensors nicht beeinträchtigt, aber zugleich sichergestellt, dass der Empfangslichtfleck 26 auch einen schmalen Zeilensensor in einem großen Toleranzbereich trifft.

In Figur 1 trifft das Sendelicht 22 auf ein Objekt 24 mit planer, glänzender Oberfläche, die senkrecht zu der optischen Achse des Sensors 10 ausgerichtet ist. Dabei bedeutet glänzend nicht notwendig, dass keine oder kaum diffuse Remission oder Absorption des Sendelichts 22 stattfindet. Solche Effekte können sich durchaus überlagern, wie im Beispiel einer schwarz lackierten Oberfläche oder einer dünnen Folie auf einer bunt bedruckten Verpackung. Jedenfalls hat das Objekt 24 Eigenschaften, die dafür sorgen, dass zumindest ein kleiner Teil des Sendelichts 22a in die Empfangsoptik 18 reflektiert wird und den Empfangslichtfleck 26 erzeugt. Das gilt gerade für denjenigen Anteil des Sendelichts 22, bei dem die Bedingung Einfallswinkel des Sendestrahls gleich Ausfallswinkel zur Empfangsöffnung der Empfangsoptik 18 erfüllt ist.

Möchte man einfach binär die Anwesenheit des Objekts 24 erkennen, so genügt es, das Empfangssignal des Lichtempfängers 16 mit einer zuvor definierten Schwelle zu vergleichen. Wird die Schwelle oberhalb des Hintergrundsignals gewählt, so spielt es auch keine Rolle, ob das Empfangssignal durch reflektierte oder remittierte Lichtanteile verursacht ist. Aufgrund des ortsauflösenden Lichtempfängers 16 kann aber zusätzlich zwischen diesen Lichtanteilen unterschieden werden, da der durch Glanz verursachte reflektierende Lichtanteil einen begrenzten Empfangslichtfleck 26 erzeugt. Die Position des Empfangslichtflecks 26 ermöglicht auch, auf den Winkel zu schließen, unter dem die Oberfläche des Objekts 24 zu der optischen Achse des Sensors 10 steht. Dies kann als Zusatzmerkmal von dem Sensor 10 ausgegeben werden.

Die Figuren 2a und 2b zeigen zwei Beispiele eines unterschiedlich zu dem Sensor 10 geneigten Objekts 24. Dabei bezeichnen hier und im Folgenden die gleichen Bezugszeichen die gleichen Merkmale. Wie den Figuren 2a-b unmittelbar zu entnehmen ist, erkennt der Sensor 10 ein spiegelndes oder glänzendes Objekt 24 zuverlässig auch bei einem Verkippen innerhalb eines Winkeltoleranzbereichs des Sensors 10. Die Position des Empfangslichtflecks wandert je nach Verkippen des Objekts 24 auf dem Lichtempfänger 16 nach rechts oder links. Aus dieser Position kann die Auswertungseinheit 20 den Winkel bestimmen. Der Winkeltoleranzbereich wird dadurch begrenzt, dass der Empfangslichtfleck 26 bei zu großem Winkel nicht mehr auf dem Lichtempfänger 16 abgebildet wird.

Auf den ersten Blick ist der Energieverlust des Sensors 10 extrem groß. Bei transparenten Objekten werden nur 4%, mit Oberflächenvergütung sogar nur etwa 1% der Energie reflektiert. Durch die Aufweitung des Sendelichts nimmt zudem die Empfangsenergie quadratisch mit dem Objektabstand ab. Dies wird aber dadurch überkompensiert, dass die reflektierte Energie in der Regel um Dekaden höher als bei remittierenden Objekten ist. Auch unter ungünstigen Bedingungen, beispielsweise einer Glasscheibe als zu detektierendem Objekt, empfängt der Sensor 10 mehr Licht als eine herkömmliche energetische Lichtschranke von einem Weißtarget.

Eine häufige Anwendung schaltender Sensoren ist die Überwachung eines Objektstroms, beispielsweise an einem Förderband. Hier wird nicht nur erwartet, dass ein Objekt 24 überhaupt erkannt wird, sondern es soll auch in einer präzisen Erfassungsposition geschaltet werden, beispielsweise bei Überschreiten einer virtuellen Linie durch die erste Objektkante. Variiert der Schaltzeitpunkt gegenüber dieser gewünschten Erfassungsposition, so können nachgelagerte Bearbeitungsschritte beeinträchtigt werden, die jedes erkannte Objekt 24 in einer definierten Position vorfinden sollen.

Wie in Figur 2 illustriert, ist aber die Erfassungsposition von der Neigung des Objekts 24 abhängig. Denn bei Bewegung des Objekts 24 in der durch den Pfeil 28 angedeuteten Förderrichtung wird das gemäß Figur 2b nach rechts geneigte Objekt 24 wesentlich eher einen Teil des Sendelichts 22 in die Empfangsoptik 17 reflektieren als das gemäß Figur 2a nach links geneigte Objekt 24. Denn das nach rechts geneigte Objekt 24 spiegelt das Sendelicht 22 praktisch in Förderrichtung voraus, während bei dem nach links geneigten Objekt 24 erst gewartet werden muss, bis das gegen die Förderrichtung gespiegelte Sendelicht 22 die Empfangsoptik 18 treffen kann.

Eine weitere Abhängigkeit vom Objektabstand ist weniger kritisch, da dieser Abstand oft durch die Anwendung konstant gehalten werden kann, beispielsweise durch Erfassen gleichartiger Objekte von oben. Natürlich kann man sich auch von der Winkelabhängigkeit befreien, indem man die Orientierung der Objekte 24 durch die Anwendung vorgibt.

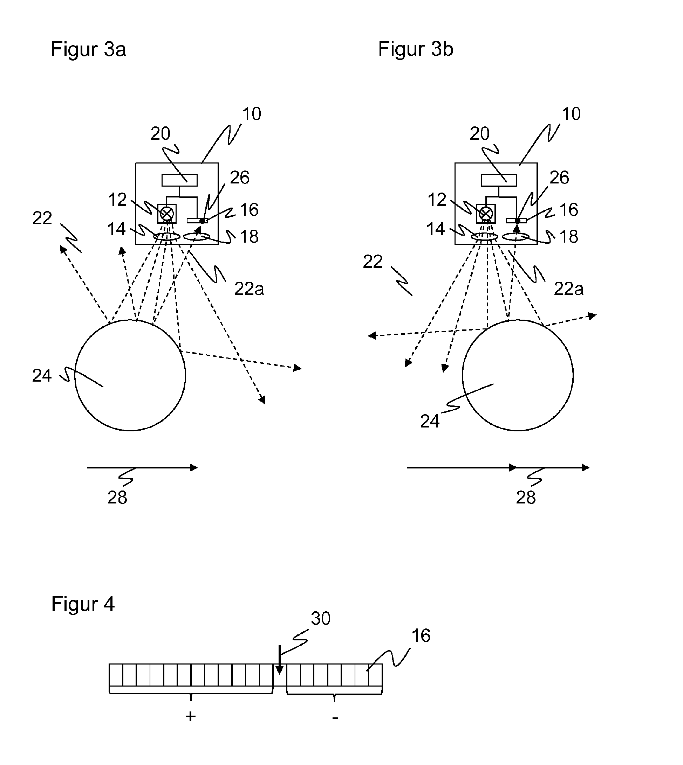

Der Sensor 10 ist jedoch auch in der Lage, bei unbekanntem Objektwinkel die Erfassungsposition festzulegen. Figur 3 zeigt ein erstes Beispiel mit runden Objekten 24, beispielsweise seitlich erfassten, aufrecht stehenden Flaschen. Die Rundung reflektiert das auftreffende Sendelicht 22 in alle Richtungen, also auch in Richtung des Lichtempfängers 16. Je nachdem, welcher Bereich der runden Kontur des Objekts 24 den Empfangslichtfleck 26 erzeugt, liegt diese an einer bestimmten Position auf dem Lichtempfänger 16. Aus dem typischen Winkelverlauf des runden Objekts 24 erkennt deshalb die Auswertungseinheit 20 die Position des runden Objekts 24 anhand der Position des Empfangslichtflecks 26, wie in den Figuren 3a und 3b an zwei verschiedenen Positionen illustriert.

Die Position des Empfangslichtflecks 20 kann von der Auswertungseinheit in einer Art Bildverarbeitung festgestellt werden. Eine einfachere Möglichkeit wird unter Bezug auf Figur 4 erläutert. Dort ist der Lichtempfänger 16 mit seinen einzelnen Lichtempfangselementen oder Pixeln dargestellt. Auf dem Lichtempfänger 16 wird eine durch den Pfeil gekennzeichnete Schaltposition 30 festgelegt. Diese Schaltposition 30 wird so gewählt, dass sie der gewünschten Erfassungsposition des Objekts 24 entspricht. Das kann wahlweise durch relatives Verschieben des Sensors 10 oder durch elektronische Festlegung der Schaltposition 30 auf dem Lichtempfänger 16 geschehen. Die Signale der einzelnen Pixel werden nun aufsummiert, und zwar mit Gewichtungsfaktoren, die auf der einen Seite der Schaltposition 30 positiv und auf der anderen Seite der Schaltposition 30 negativ sind. Eine einfache Implementierung sieht lediglich Gewichtungsfaktoren von ±1 vor. Das Pixel an der Schaltposition 30 bleibt unberücksichtigt oder wird mit einem Gewichtungsfaktor zwischen -1 und +1 summiert. Dadurch wird sogar eine Subpixelauflösung für die Schaltposition 30 denkbar, insbesondere wenn auch in einer Nachbarschaft der Schaltposition Pixel mit Gewichtungsfaktoren mit Betrag <1 gewichtet werden und der Empfangslichtfleck vorzugsweise mindestens drei Pixel überdeckt.

Das Summensignal muss dann lediglich noch mit einer Schaltschwelle verglichen werden. Der Empfangslichtfleck 26 bewegt sich während der Förderbewegung des Objekts 24 auf dem Lichtempfänger von rechts nach links. Deshalb steigt aufgrund der Gewichtungsfaktoren das Summensignal in einer Umgebung der Schaltposition 30 von einem negativen zu einem positiven Wert an. So kann das Passieren der Schaltposition 30 durch den Empfangslichtfleck 26 mit einer Schwelle beispielsweise um Null und vorzugsweise leicht positiv erkannt werden. Dies entspricht im Überwachungsbereich des Sensors 10 gerade dem Passieren der Erfassungsposition durch das Objekt 24.

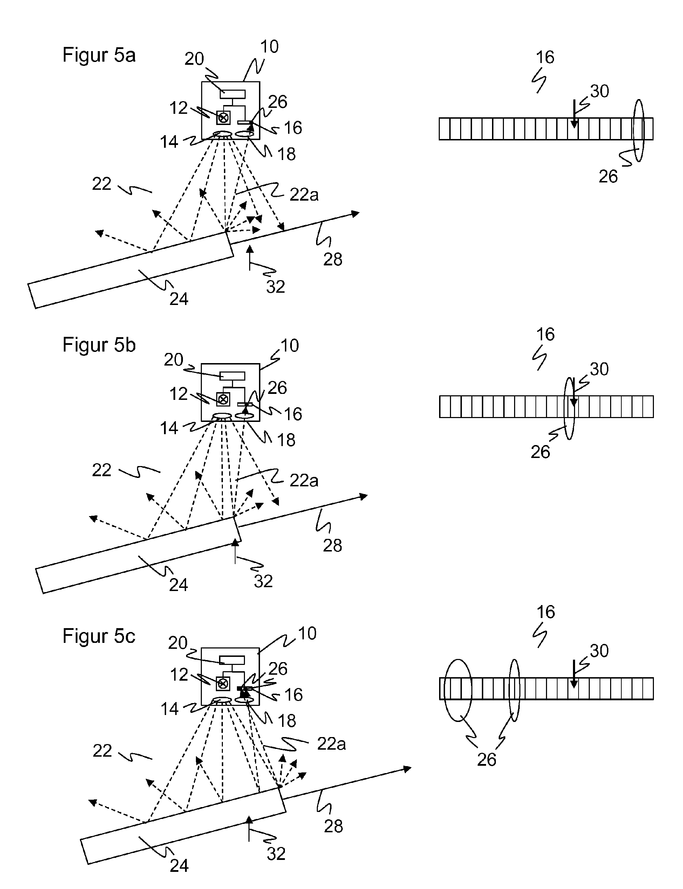

Figur 5 illustriert ein weiteres Beispiel bei Erfassung flacher statt runder Objekte 24. Viele derartige Objekte 24 sind in der Praxis am Übergang zur Stirnseite abgerundet. Diese Kante wird detektiert, so dass es auf den beispielhaft dargestellten rechteckigen Querschnitt des Objekts 24 nicht ankommt. Vorzugsweise steht die Förderrichtung 28 schräg zu der optischen Achse des Sensors 10, damit nicht ein Reflex von der flachen Seite des Objekts 24 vor der abgerundeten Kante zu einem verfrühten Schalten führt.

Die Figuren 5a-c zeigen jeweils im linken Teil das Objekt 24 in verschiedenen Förderpositionen, nämlich in Figur 5a vor der Erfassungsposition, in Figur 5b in der Erfassungsposition und in Figur 5c nach der Erfassungsposition. Im rechten Teil wird der Lichtempfänger 16 mit den dabei entstehenden Empfangslichtflecken 26 dargestellt. Der Empfangslichtfleck 26 ist nicht kreisförmig, sondern wie in einer bevorzugten Ausführungsform in Zeilenrichtung fokussiert und senkrecht zu der Zeilenrichtung langgezogen, was beispielsweise durch eine torische Linse der Empfangsoptik 18 erreicht wird.

Aufgrund der negativen Gewichtung der rechts von der Schaltposition 30 befindlichen Pixel bleibt das Summensignal in Figur 5a negativ. Der Sensor 10 schaltet daher noch nicht, obwohl bereits ein Empfangslichtfleck 26 von einer Reflexion an der zu detektierenden Kante entsteht.

In der Situation der Figur 5b wurde das Objekt 24 in die Erfassungsposition 32 gefördert. Dementsprechend befindet sich der Empfangslichtfleck 26 an der Schaltposition 30, also an dem Übergangsbereich zwischen negativen und positiven Gewichtungsfaktoren. Das Summensignal beträgt hier in etwa Null. Verschiebt man also das Objekt 24 ein wenig nach rechts, d. h. in Förderrichtung, so wird das Summensignal positiv, dagegen bei Verschieben in die Gegenrichtung negativ. Mit einer Schaltschwelle im Bereich des Nullsignals, vorzugsweise etwas größer Null, wird kann deshalb die vordere Objektkante präzise detektiert werden.

Auch nach Passieren der Erfassungsposition bleibt ein Empfangslichtfleck 26 von der vorderen Objektkante auf dem Lichtempfänger 16 im Bereich der positiven Gewichtungsfaktoren. Hinzu kommt nun ein weiterer Empfangslichtfleck 26 von der dem Sensor 10 zugewandten Objektfläche. Dessen Position hängt vom Objektwinkel ab. Obwohl der Sensor 10 eine relativ große Winkeltoleranz hat, sollte darauf geachtet werden, dass der Objektwinkel keinen Empfangslichtfleck 26 im Bereich der negativen Gewichtungsfaktoren erzeugt und damit eventuell ein Fehlschalten auslöst. Das Objekt 24 darf also nicht zu stark in Förderrichtung geneigt sein, was auch zu einem vorauseilenden Reflex und einem verfrühten Schalten entgegen der Situation der Figur 5a führen würde. Unter diesen Bedingungen schaltet der Sensor 10 wie gewünscht gerade so lange, bis das Objekt 24 wieder auf dem Erfassungsbereich ausgefahren ist.

In einer weiteren Ausführungsform des Sensors 10 werden Oberflächeneigenschaften erkannt. Ein diffus abstrahlendes Objekt 24 erzeugt in der Regel einen eher homogen ausgedehnten Empfangslichtfleck, Glanz dagegen eher einen örtlich begrenzten Empfangslichtfleck 26. Daher kann der Sensor 10 anhand der Ausdehnung des Empfangslichtflecks 26 Glanz erkennen und daraus beispielsweise ein Schaltsignal ableiten.

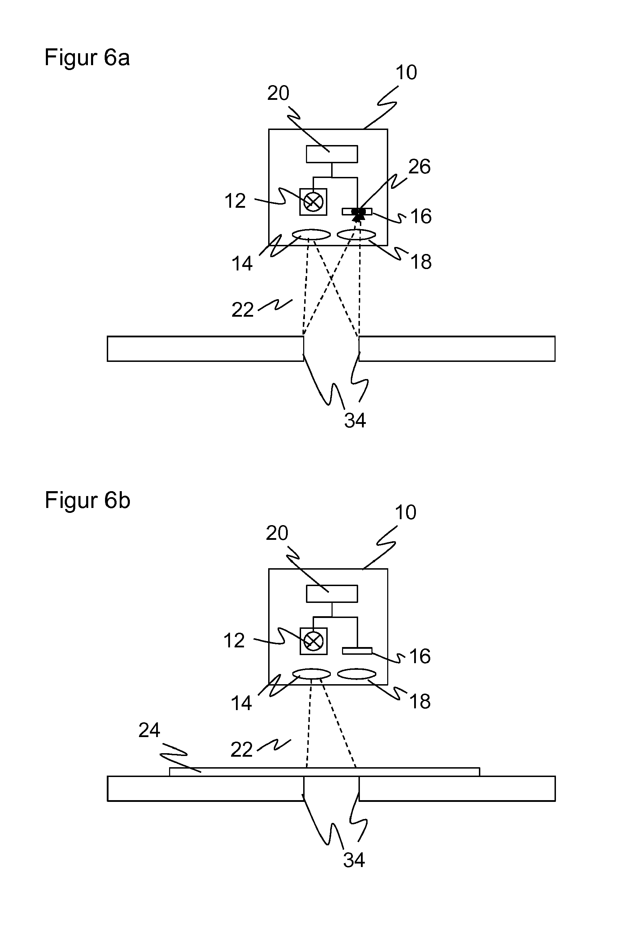

Figur 6 illustriert eine weitere mögliche Anwendung des Sensors 10. Wie in Figur 6a dargestellt, wird im Sichtbereich des Sensors 10 ein Referenzobjekt 34 angeordnet, hier ein Loch, dessen glänzende Begrenzung als Referenz erfasst wird. Dazu wird das Sendelicht 22 hinreichend aufgeweitet, um den Radius des Lochs zu umfassen. Es entstehen zwei Empfangslichtflecke 26 von den Randbereichen des Lochs, welche somit die Erwartungshaltung des Sensors 10 bei Erfassung des Referenzobjekts 34 bilden. Durch die Position des Lochs kann auch die Erfassungsposition 32 und damit die Schaltposition 34 festgelegt werden. Der Sensor 10 muss deshalb nicht mehr selbst exakt ausgerichtet werden.

Befindet sich nun wie in Figur 6b ein Objekt 24 vor dem Referenzobjekt 34, so registriert der Lichtempfänger 16 die veränderte Situation. Es genügt ein dünnes flächiges Objekt 24, beispielsweise ein Blatt Papier. Aufgrund von dessen eher diffusem Verhalten wird die empfangene Lichtverteilung eher homogen und unterscheidet sich deutlich von den als Referenz bekannten beiden Empfangslichtflecken 26 gemäß Figur 6a. Es ist nicht einmal erforderlich, dass das Objekt 24 diffuse Remissionseigenschaften hat, denn auch der durch einen Glanz entstehende Empfangslichtfleck 26 würde sich von den beiden Empfangslichtflecken 26 des Referenzobjekts 34 in deutlich erkennbarer Weise unterscheiden.

## Patentansprüche

1. Optoelektronischer Sensor (10) zur Erfassung glänzender Objekte (24), wobei der Sensor (10) einen Lichtsender (12) zum Aussenden eines divergenten Strahlenbündels (22), einen ortsauflösenden Lichtempfänger (16) sowie eine Auswertungseinheit (20) aufweist, um bei Erfassen eines Objekts (24) an einer Erfassungsposition (30) ein Schaltsignal zu erzeugen,
**dadurch gekennzeichnet,**
**dass** die Auswertungseinheit (20) dafür ausgebildet ist, auf dem Lichtempfänger (16) eine Schaltposition (32) entsprechend der Erfassungsposition (30) festzulegen und das Schaltsignal in Abhängigkeit von der Position eines Empfangslichtflecks (26) auf dem Lichtempfänger (16) bezüglich der Schaltposition (32) zu erzeugen.

2. Sensor (10) nach Anspruch 1,
wobei die Auswertungseinheit (20) dafür ausgebildet ist, ein Summensignal des Lichtempfängers (16) zu bilden, zu dem die Positionen des Lichtempfängers (16) mit einem Gewichtungsfaktor beitragen, der anhand der jeweiligen Position und der Schaltposition (32) festgelegt ist.

3. Sensor (10) nach Anspruch 2,
wobei die Schaltposition (32) den Lichtempfänger (16) in zwei Bereiche teilt,
wobei Positionen in dem einen Bereich mit einem positiven Gewichtsfaktor und Positionen in dem anderen Bereich mit einem negativen Gewichtsfaktor zu dem Summensignal beitragen.

4. Sensor (10) nach einem der vorhergehenden Ansprüche,
wobei die Auswertungseinheit (20) dafür ausgebildet ist, die Schaltposition (32) zu verschieben.

5. Sensor (10) nach einem der vorhergehenden Ansprüche,
wobei dem Lichtsender (12) eine Streulinse (14) vorgeordnet ist.

6. Sensor (10) nach einem der vorhergehenden Ansprüche,
wobei der Lichtempfänger (16) eine Vielzahl zeilenförmig angeordneter Lichtempfangselemente aufweist.

7. Sensor (10) nach einem der vorhergehenden Ansprüche,
wobei dem Lichtempfänger (16) eine torische Empfangslinse (18) vorgeordnet ist.

8. Sensor (10) nach einem der vorhergehenden Ansprüche,
wobei die Auswertungseinheit (20) dafür ausgebildet ist, ein glänzendes Objekt (24) anhand der Größe eines Empfangslichtflecks (26) zu erkennen.

9. Sensor (10) nach einem der vorhergehenden Ansprüche,
wobei die Auswertungseinheit (20) dafür ausgebildet ist, die Empfangssignale eines glänzenden Referenzhintergrundes (34) als Referenzsignal einzulernen und ein Objekt (24) vor dem Referenzhintergrund (34) anhand einer Veränderung gegenüber dem Referenzsignal zu erkennen.

10. Verfahren zum Erzeugen eines Schaltsignals bei Erfassung eines glänzenden Objekts (24) an einer Erfassungsposition (30), bei dem ein divergentes Strahlenbündel (22) in einen Überwachungsbereich ausgesandt und Empfangslicht aus dem Überwachungsbereich auf einem ortsaufgelösten Lichtempfänger (16) erfasst wird,
**dadurch gekennzeichnet,**
**dass** auf dem Lichtempfänger (16) eine Schaltposition (32) entsprechend der Erfassungsposition (30) festgelegt und das Schaltsignal in Abhängigkeit von der Position eines Empfangslichtflecks (26) auf dem Lichtempfänger (16) bezüglich der Schaltposition (32) erzeugt wird.

## Geänderte Patentansprüche

### Geänderte Patentansprüche gemäss Regel 137(2) EPÜ.

1. Optoelektronischer Sensor (10) zur Erfassung glänzender Objekte (24), wobei der Sensor (10) einen Lichtsender (12), einen ortsauflösenden Lichtempfänger (16) sowie eine Auswertungseinheit (20) aufweist, die dafür ausgebildet ist, auf dem Lichtempfänger (16) eine Schaltposition (32) entsprechend einer Erfassungsposition (30) festzulegen und bei Erfassen eines Objekts (24) an der Erfassungsposition (30) ein Schaltsignal in Abhängigkeit von der Position eines Empfangslichtflecks (26) auf dem Lichtempfänger (16) bezüglich der Schaltposition (32) zu erzeugen,
**dadurch gekennzeichnet,**
**dass** dem Lichtsender zum Aussenden eines divergenten Strahlenbündels (22) eine Streulinse (14) vorgeordnet ist.

2. Sensor (10) nach Anspruch 1,
wobei die Auswertungseinheit (20) dafür ausgebildet ist, ein Summensignal des Lichtempfängers (16) zu bilden, zu dem die Positionen des Lichtempfängers (16) mit einem Gewichtungsfaktor beitragen, der anhand der jeweiligen Position und der Schaltposition (32) festgelegt ist.

3. Sensor (10) nach Anspruch 2,
wobei die Schaltposition (32) den Lichtempfänger (16) in zwei Bereiche teilt, wobei Positionen in dem einen Bereich mit einem positiven Gewichtsfaktor und Positionen in dem anderen Bereich mit einem negativen Gewichtsfaktor zu dem Summensignal beitragen.

4. Sensor (10) nach einem der vorhergehenden Ansprüche,
wobei die Auswertungseinheit (20) dafür ausgebildet ist, die Schaltposition (32) zu verschieben.

5. Sensor (10) nach einem der vorhergehenden Ansprüche,
wobei der Lichtempfänger (16) eine Vielzahl zeilenförmig angeordneter Lichtempfangselemente aufweist.

6. Sensor (10) nach einem der vorhergehenden Ansprüche,
wobei dem Lichtempfänger (16) eine torische Empfangslinse (18) vorgeordnet ist.

7. Sensor (10) nach einem der vorhergehenden Ansprüche,
wobei die Auswertungseinheit (20) dafür ausgebildet ist, ein glänzendes Objekt (24) anhand der Größe eines Empfangslichtflecks (26) zu erkennen.

8. Sensor (10) nach einem der vorhergehenden Ansprüche,
wobei die Auswertungseinheit (20) dafür ausgebildet ist, die Empfangssignale eines glänzenden Referenzhintergrundes (34) als Referenzsignal einzulernen und ein Objekt (24) vor dem Referenzhintergrund (34) anhand einer Veränderung gegenüber dem Referenzsignal zu erkennen.

9. Verfahren zum Erzeugen eines Schaltsignals bei Erfassung eines glänzenden Objekts (24) an einer Erfassungsposition (30), bei dem ein Strahlenbündel (22) in einen Überwachungsbereich ausgesandt und Empfangslicht aus dem Überwachungsbereich auf einem ortsaufgelösten Lichtempfänger (16) erfasst wird, wobei auf dem Lichtempfänger (16) eine Schaltposition (32) entsprechend der Erfassungsposition (30) festgelegt und das Schaltsignal in Abhängigkeit von der Position eines Empfangslichtflecks (26) auf dem Lichtempfänger (16) bezüglich der Schaltposition (32) erzeugt wird,
**dadurch gekennzeichnet,**
**dass** mit Hilfe einer Streulinse (14) ein divergentes Strahlenbündel (22) ausgesandt wird.
